# EUROPEAN PATENT APPLICATION

(11) **EP 0 948 044 A1**
(43) Date of publication of application: **06.10.1999**
(21) Application number: 99105871.0
(22) Date of filing: 23.03.1999
(51) Int. Cl.: H01L 21/762

(54) **Trench isolated wells in a semiconductor device**

(30) Priority: 25.03.1998 JP 7799098
(71) Applicant: NEC CORPORATION, Tokyo (JP)
(72) Inventor: Kumashiro, Shigetaka, Minato-ku, Tokyo (JP)
(74) Representative: Glawe, Delfs, Moll & Partner

(57) **Abstract**

A semiconductor device of the present invention has such an isolation structure that a trench is formed between an n-well layer and a p-well layer that are formed on a Si substrate, and the trench is filled with SiO₂. Phosphorus is used as an n-type impurity constructing the n-well layer, boron is used as a p-type impurity constructing the p-well layer, and a peak of concentration distribution of boron lies in a part of a side wall of the trench.

## Description

### BACKGROUND OF THE INVENTION

### Field of the Invention

The present invention relates to a semiconductor device, and in particular, to a semiconductor isolation structure having a high isolation withstand voltage.

### Description of the Prior Art

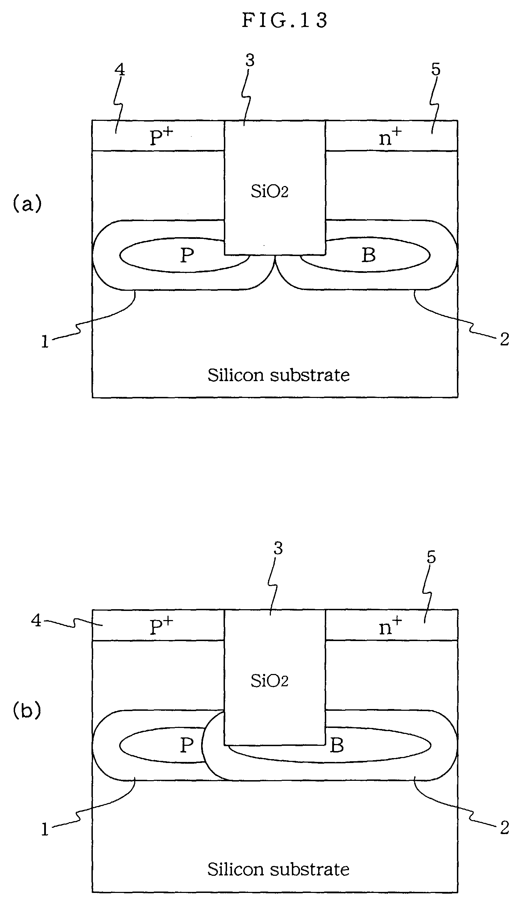

For example, in a conventional semiconductor device having a common CMOS structure, as shown in FIGS. 13(a) and 13(b), when isolation is performed by a trench filled with a buried oxide film (SiO₂) 3 between an n-well layer 1 and a p-well layer 2, as shown in FIG. 13(a), phosphorus (P) is used in the n-well layer 1 as an impurity, boron (B) is in the p-well layer 2, and they are ion-implanted. At this time, ion implantation conditions are set so that both peaks of distributions of phosphorus ions and boron ions may lie in the bottom of the trench, and are set so that a junction of two impurity distributions may lie in the center of the trench isolation structure. A p⁺ diffused layer 4 forms a source and a drain of a p-channel transistor formed on the n-well layer. An n⁺ diffused layer 5 forms a source and a drain of an n-channel transistor formed on the p-well layer.

Another related art is disclosed in Japanese Unexamined Application No. A-4-297062. Objection of this related art is method of manufacturing semiconductor device having high insulation and lowered amplifier ratio. Wherein the semiconductor device is PNP type transistor.

### BRIEF SUMMARY OF THE INVENTION

### Object of the Invention

By the way, as shown in FIG. 13(b), boron and phosphorus perform enhanced diffusion in a subsequent heat treatment process due to point-defects caused by ion implantation into the well layers, and source and drain. The boron and phosphorus performing the enhanced diffusion are piled up toward a boundary between a silicon substrate and an SiO₂ interface that is a sink of point-defects. Nevertheless, boron does not resemble phosphorus in behavior. Thus, although boron piled up keeps an active state, phosphorus becomes inactive. Therefore, the concentration of boron becomes superior to that of phosphorus in the bottom portion of the trench where the n-well layer 1 contacts to the p-well layer 2, and hence the bottom portion becomes a p-type region. Therefore, since the p-well layer 2 extends to the bottom portion of the trench, an effective distance between the p-well layer 2 and p⁺ diffused layer 4 becomes small. Hence, a punch-through withstand voltage between the p-well layer 2 and p⁺ diffused layer 4 becomes lower than that between the n-well layer 1 and n⁺ diffused layer 5. In consequence, there arises a problem that various device characteristics are deteriorated as an isolation withstand voltage is decreased.

The present invention is performed to solve above problem and to provide a semiconductor device that has a high isolation withstand voltage by preventing a punch-through withstand voltage between the p-well layer and p⁺ diffused layer from decreasing in an isolation structure that separates the n-well layer from the p-well layer with the trench.

### Summary of the Invention

In order to achieve above object, a semiconductor device according to a first form of the present invention is characterized in that a peak of a concentration distribution of boron, which constructs a p-well layer, in the direction of substrate depth lies in a side wall portion of a trench.

In this semiconductor device, since the peak of a concentration distribution of boron in the direction of substrate depth lies in the side wall portion of the trench, the pileup of boron occurs with the side wall of the trench as the center, not in the bottom portion of the trench. Therefore, it is possible to prevent the punch-through withstand voltage between a p-well layer and a p⁺ diffused layer from decreasing since it is rare that the bottom portion of the trench becomes a p-type region.

A semiconductor device according to a second form of the present invention is characterized in that a peak of a concentration distribution of an n-type impurity, which constructs the n-well layer, in the direction of substrate depth lies at a position shallower than a peak of a concentration distribution of boron, which constructs the p-well layer, in the direction of substrate depth.

In this semiconductor device, the peak of the concentration distribution of the n-type impurity such as arsenic (As) is shallower than that of boron. Therefore, even if boron is piled up in the bottom portion of the trench and hence the bottom portion of the trench becomes a p-type region, it is possible to prevent the punch-through between the bottom portion of the trench and the p⁺ diffused layer. This is because there is a portion (n⁺ layer) having the high concentration of n-type impurity between the bottom portion of the trench and the p⁺ diffused layer.

A semiconductor device according to a third form of the present invention is characterized in that a junction of a concentration distribution of an n-type impurity and a concentration distribution of boron lies nearer to the concentration distribution of boron than to the center of the trench.

In this semiconductor device, since the peak of the concentration distribution of boron is far from the bottom portion of the trench, the pileup quantity of boron to the bottom portion of the trench decreases. In addition, since the concentration of the n-type impurity in the bottom portion of the trench becomes high, it is possible to compensate the influence of inactivation caused by the pileup. In consequence, since the bottom portion of the trench does not become a p-type region, it is possible to prevent the punch-through withstand voltage between the p-well layer and p⁺ diffused layer from decreasing.

A semiconductor device according to a fourth form of the present invention is characterized in that a concentration of an n-type impurity constructing an n-well layer is higher than that of boron constructing a p-well layer.

In this semiconductor device, since the concentration of the n-type impurity is high, it is possible to compensate the influence of the inactivation caused by the pileup. In addition, even if a bottom portion of a trench becomes a p-type region, the n-type impurity serves as a punch-through stopper. In consequence, it is possible to suppress the punch-through between the bottom portion of the trench and p⁺ diffused layer.

A semiconductor device according to a fifth form of the present invention is characterized in that a trench is formed in such a wedge-like shape that the side near to the surface of the silicon substrate is wide and the side near to the bottom portion is narrow, and that at least a peak of a concentration distribution of boron, constructing a p-well layer, in the direction of substrate depth lies in a side wall portion of the wedge-like trench.

In this semiconductor device, since the area of the bottom portion of the trench is small, the pileup of boron occurs toward the side wall of the trench, not in the bottom portion of the trench. Therefore, it is possible to enclose the influence of a redistribution of boron within a region from the center of the trench structure to the part of the p-well layer.

In consequence, it is possible to suppress the punch-through between the p-well layer and p⁺ diffused layer.

A semiconductor device according to a sixth form of the present invention is characterized in that As is used as an n-type impurity constructing an n-well layer.

In this semiconductor device, since the extent of enhanced diffusion of As is smaller than that of phosphorus among n-type impurities. Therefore, since a rate of pileup of As within the boundary between the silicon substrate and silicon oxide film is small, it is possible to decrease the influence of inactivation. In consequence, since it is rare that a bottom portion of a trench becomes a p-type region, it is possible to prevent the punch-through withstand voltage between the p-well layer and p⁺ diffused layer from decreasing.

In addition, basically, it is possible to obtain the above effects by the above characteristic structures in a semiconductor device of the present invention so long as these characteristic structures are formed before heat treatment after ion implantation of a p-type impurity and an n-type impurity. Nevertheless, these structures are maintained in a complete state of semiconductor device that passed through the heat treatment.

### BRIEF DESCRIPTION OF THE DRAWINGS

FIG. 1 is a cross-sectional view showing an isolation structure of a semiconductor device according to a first embodiment of the present invention;
FIG. 2 is a cross-sectional view showing an isolation structure of a semiconductor device according to a second embodiment of the present invention;
FIG. 3 is a cross-sectional view showing an isolation structure of a semiconductor device according to a third embodiment of the present invention;
FIG. 4 is a cross-sectional view showing an isolation structure of a semiconductor device according to a fourth embodiment of the present invention;
FIG. 5 is a cross-sectional view showing an isolation structure of a semiconductor device according to a fifth embodiment of the present invention;
FIG. 6 is a cross-sectional view showing an isolation structure of a semiconductor device according to a sixth embodiment of the present invention;
FIGS. 7(a) through 7(d) are cross-sectional views showing a production method of the semiconductor device according to the first embodiment in the order of process steps;
FIGS. 8(a) through 8(d) are cross-sectional views showing a production method of the semiconductor device according to the second embodiment in the order of process steps;
FIGS. 9(a) through 9(d) are cross-sectional views showing a production method of the semiconductor device according to the third embodiment in the order of process steps;
FIGS. 10(a) through 10(d) are cross-sectional views showing a production method of the semiconductor device according to the fourth embodiment in the order of process steps;
FIGS. 11(a) through 11(f) are cross-sectional views showing a production method of the semiconductor device according to the fifth embodiment in the order of process steps;
FIGS. 12(a) through 12(d) are cross-sectional views showing a production method of the semiconductor device according to the sixth embodiment in the order of process steps; and
FIG. 13 is a cross-sectional view showing an isolation structure of a conventional semiconductor device.

### DETAILED DESCRIPTION OF THE PREFERRED EMBODIMENTS

Hereinafter, embodiments of the present invention will be described with reference to drawings.

### (First embodiment)

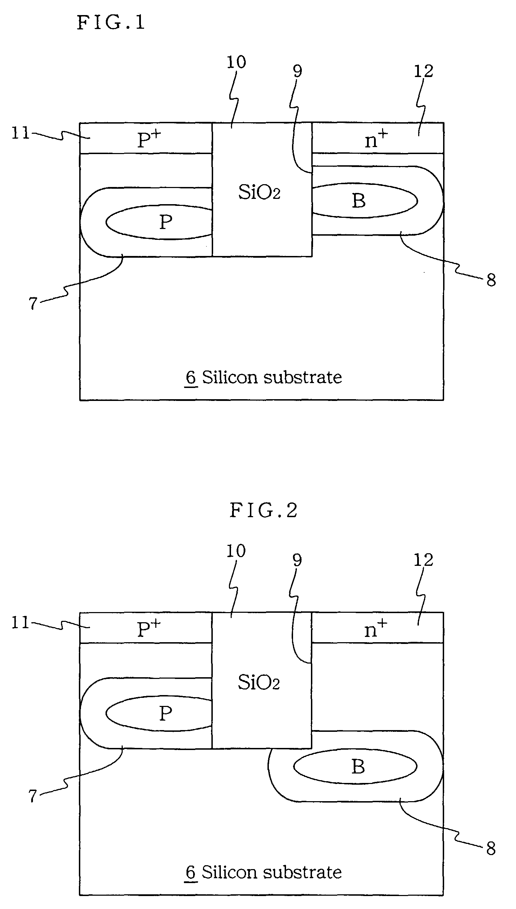

FIG. 1 is a cross-sectional view showing an isolation structure of a semiconductor device of this embodiment. In the semiconductor device of this embodiment, as shown in FIG. 1, a trench 9 is formed between an n-well layer 7 and p-well layer 8, that are formed on a Si substrate 6 and SiO₂ 10 fills the trench 9. Therefore, this semiconductor device has such an isolation structure that the n-well layer 7 is isolated from the p-well layer 8 by the trench 9. In addition, a p⁺ diffused layer 11 forms a source and drain of a p-channel transistor formed on the n-well layer 7. An n⁺ diffused layer 12 forms a source and drain of an n-channel transistor formed on the p-well layer 8.

Phosphorus (P) is used as an n-type impurity constructing the n-well layer 7, and boron (B) is used as the p-type impurity constructing the p-well layer 8. In addition, a peak of a concentration distribution of boron in the direction of substrate depth lies in a side wall portion of the trench 9. The position of a peak of a concentration distribution of phosphorus in the direction of the substrate depth is optional.

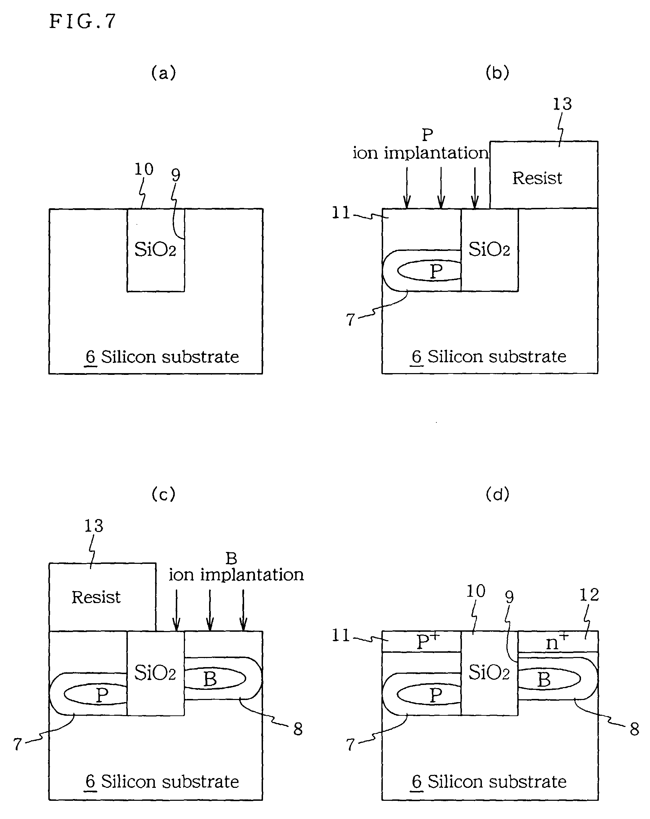

A production method of the semiconductor device having the above structure will be described with reference to FIGS. 7(a) through 7(d).

First, as shown in FIG. 7(a), the trench 9 is formed on a silicon substrate 6 with using a well-known method, and a trench isolation structure is formed by filling the trench 9 with SiO₂ 10.

Next, as shown in FIG. 7(b), the part of the p-well layer 8 is masked with a resist 13 and the like, and phosphorus is ion-implanted in the part of the n-well layer 7. After the ion implantation, the resist 13 is removed.

After that, as shown in FIG. 7(c), the part of the n-well layer 7 is masked with the resist 13 and the like, and boron is ion-implanted in the part of the p-well layer 8. At this time, since the relation between the ion implantation energy and the implantation range is known beforehand, the ion implantation energy is controlled so that the implantation range of boron may lie in the side wall portion that is upper than the bottom portion of the trench 9. After the ion implantation, the resist 13 is removed.

Next, with using a well-known method, as shown in FIG. 7(d), the p⁺ diffused layer 11 and n⁺ diffused layer 12 that become a source and a drain of a p-channel transistor and those of a n-channel transistor respectively are formed.

In addition, the order of the ion implantation shown in FIGS. 7(b) and 7(c) can be reversed.

### (Second embodiment)

FIG. 2 is a cross-sectional view showing an isolation structure of a semiconductor device of this embodiment.

As shown in FIG. 2, a trench isolation structure itself in the semiconductor device of this embodiment is similar to that of the first embodiment.

In addition, this embodiment is characterized in that phosphorus is used as an n-type impurity constructing the n-well layer 7, and boron is used as a p-type impurity constructing the p-well layer 8. Furthermore, a position of a peak of a concentration distribution of phosphorus in the direction of substrate depth is shallower than that of a concentration distribution of boron in the direction of the substrate depth.

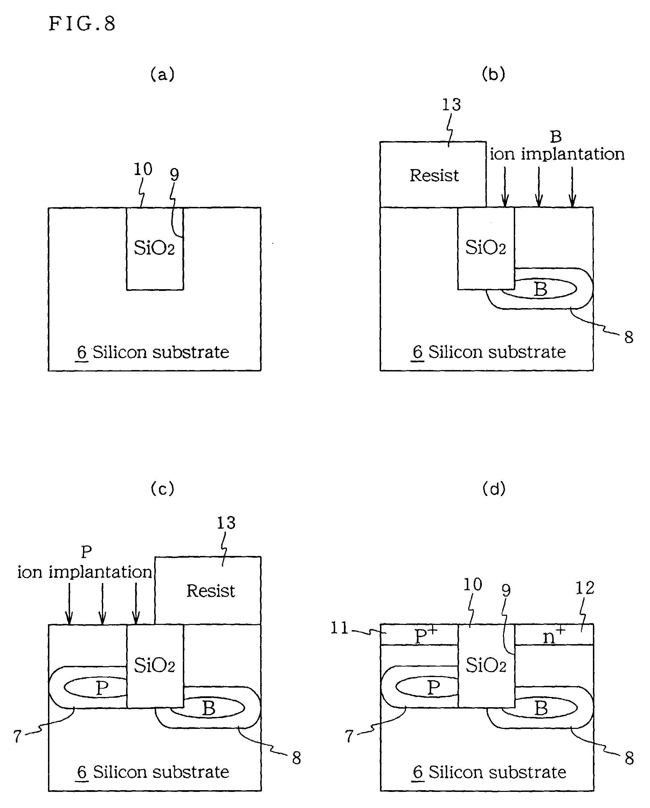

A production method of the semiconductor device having the above structure will be described with reference to FIGS. 8(a) through 8(d).

First, as shown in FIG. 8(a), the trench 9 is formed on a silicon substrate 6 with using a well-known method, and the trench isolation structure is formed by filling the trench 9 with SiO₂ 10.

Next, as shown in FIG. 8(b), the part of then-well layer 7 is masked with a resist 13 and the like, and boron is ion-implanted in the part of the p-well layer 8. After the ion implantation, the resist 13 is removed.

After that, as shown in FIG. 8(c), the part of the p-well layer 8 is masked with the resist 13 and the like, and phosphorus is ion-implanted in the part of the n-well layer 7. At the time of ion implantation of boron and phosphorus, the ion implantation energy is controlled so that the implantation range of phosphorus may become shorter than that of boron.

Next, with using a well-known method, as shown in FIG. 8(d), the p⁺ diffused layer 11 and n⁺ diffused layer 12 that become a source and a drain of a p-channel transistor and those of an n-channel transistor respectively are formed.

In addition, the order of the ion implantation shown in FIGS. 8(b) and 8(c) can be reversed.

### (Third embodiment)

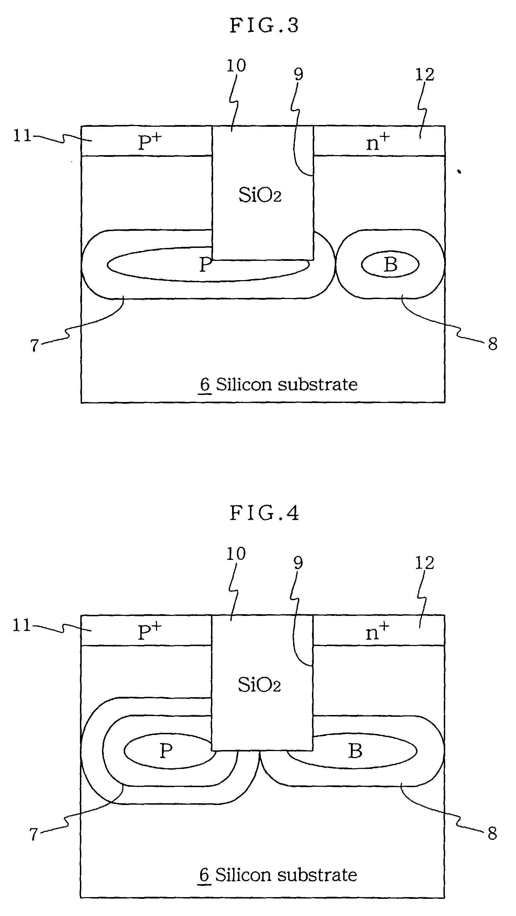

FIG. 3 is a cross-sectional view showing an isolation structure of a semiconductor device of this embodiment.

As shown in FIG. 3, a trench isolation structure itself in the semiconductor device of this embodiment is similar to those of the above embodiments.

In addition, this embodiment is characterized in that phosphorus is used as an n-type impurity constructing the n-well layer 7, and boron is used as a p-type impurity constructing the p-well layer 8. Furthermore, a junction of a concentration distribution of phosphorus and a concentration distribution of boron protrudes toward the concentration distribution of boron instead of being in the center of the trench 9.

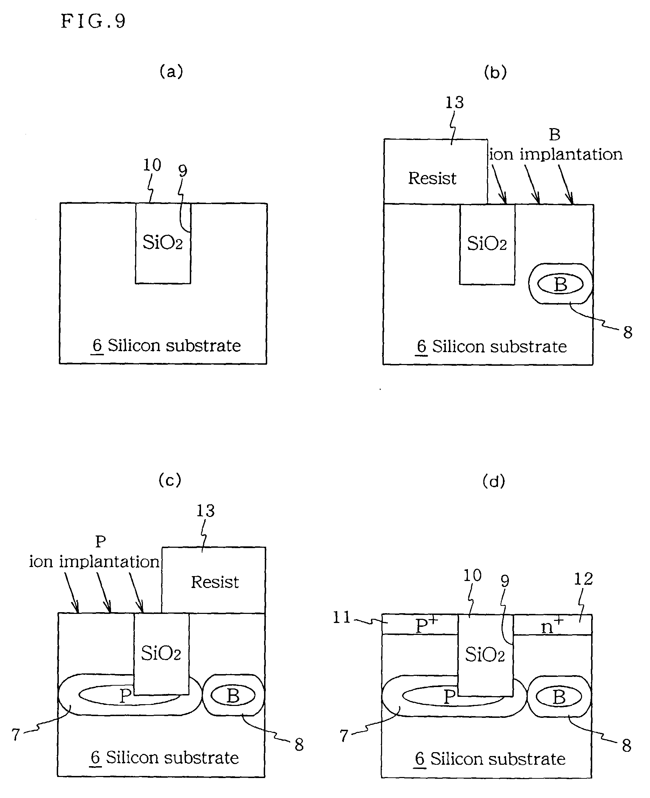

A production method of the semiconductor device having the above-described structure will be described with reference to FIGS. 9(a) through 9(d).

First, as shown in FIG. 9(a), the trench 9 is formed on a silicon substrate 6 with using a well-known method, and the trench isolation structure is formed by filling the trench 9 with SiO₂ 10.

Next, as shown in FIG. 9(b), the part of the n-well layer 7 is masked with a resist 13 and the like, and boron is ion-implanted in the part of the p-well layer 8 with inclining an ion beam toward the n-well layer 7. After the ion implantation, the resist 13 is removed.

After that, as shown in FIG. 9(c), the part of the p-well layer 8 is masked with the resist 13 and the like, and phosphorus is ion-implanted in the part of the n-well layer 7 with inclining an ion beam toward the n-well layer 7.

After that, as shown in FIG. 9(d), the p⁺ diffused layer 11 and n⁺ diffused layer 12 that become a source and a drain of a p-channel transistor and those of an n-channel transistor respectively are formed.

In addition, the order of the ion implantation of phosphorus and boron shown in FIGS. 9(b) and 9(c) can be reversed.

### (Fourth embodiment)

FIG. 4 is a cross-sectional view showing an isolation structure of a semiconductor device of this embodiment.

As shown in FIG. 4, a trench isolation structure itself in the semiconductor device of this embodiment is similar to those of the above embodiments.

In addition, this embodiment is characterized in that phosphorus is used as an n-type impurity constructing the n-well layer 7, and boron is used as a p-type impurity constructing the p-well layer 8. Furthermore, a concentration of phosphorus is higher than a concentration of boron.

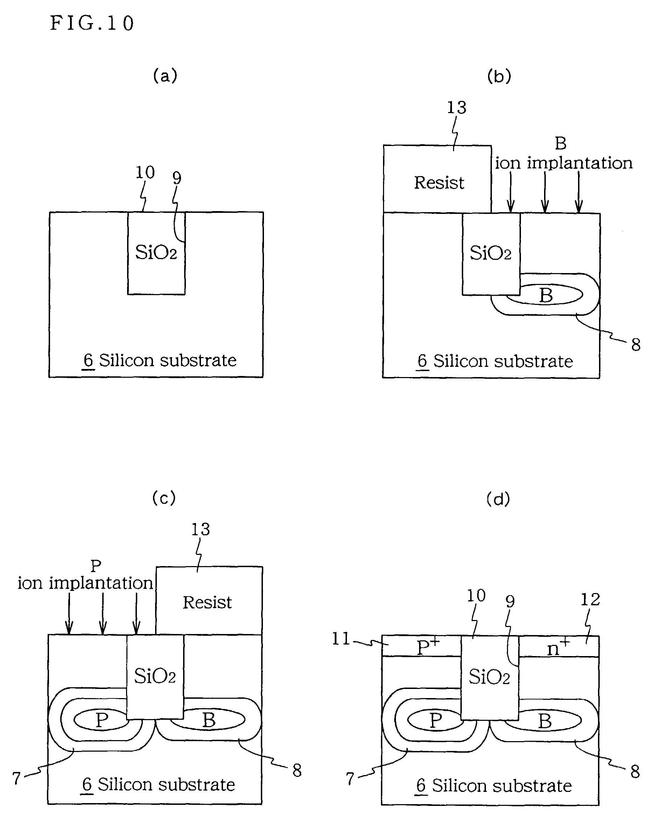

A production method of the semiconductor device having the above-described structure will be described with reference to FIGS. 10(a) through 10(d).

First, as shown in FIG. 10(a), the trench 9 is formed on a silicon substrate 6 with using a well-known method, and the trench isolation structure is formed by filling the trench 9 with SiO₂ 10.

Next, as shown in FIG. 10(b), the part of the n-well layer 7 is masked with a resist 13 and the like, and boron is ion-implanted in the part of the p-well layer 8. After the ion implantation, the resist 13 is removed. Next, as shown in FIG. 10(c), the part of the p-well layer 8 is masked with the resist 13 and the like, and phosphorus is ion-implanted in the part of the n-well layer 7. When the ion implantation of both boron and phosphorus is performed, ion implantation doses of both types of ions are controlled so that the dose of phosphorus may become more than that of boron.

After that, as shown in FIG. 10(d), the p⁺ diffused layer 11 and n⁺ diffused layer 12 that become a source and a drain of a p-channel transistor and those of an n-channel transistor respectively are formed.

In addition, the order of the ion implantation of phosphorus and boron shown in FIGS. 10(b) and 10(c) can be reversed.

### (Fifth embodiment)

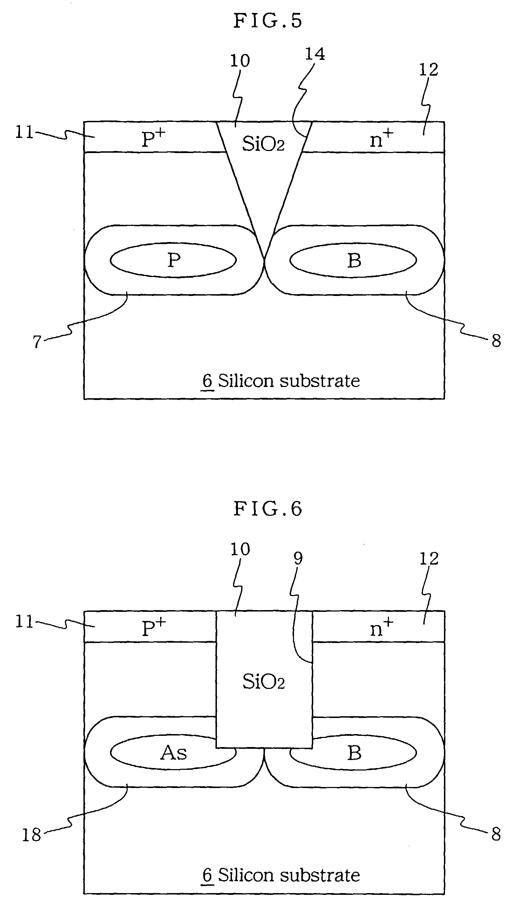

FIG. 5 is a cross-sectional view showing an isolation structure of a semiconductor device of this embodiment.

As shown in FIG. 5, in the semiconductor device of this embodiment, a trench 14 is formed in such a wedge-like shape that the side near to the surface of the silicon substrate 6 is wide and the side near to the bottom portion is narrow. Both a peak of a concentration distribution of boron and a peak of a concentration distribution of phosphorus lie in a side wall portion of the wedge-like trench 14.

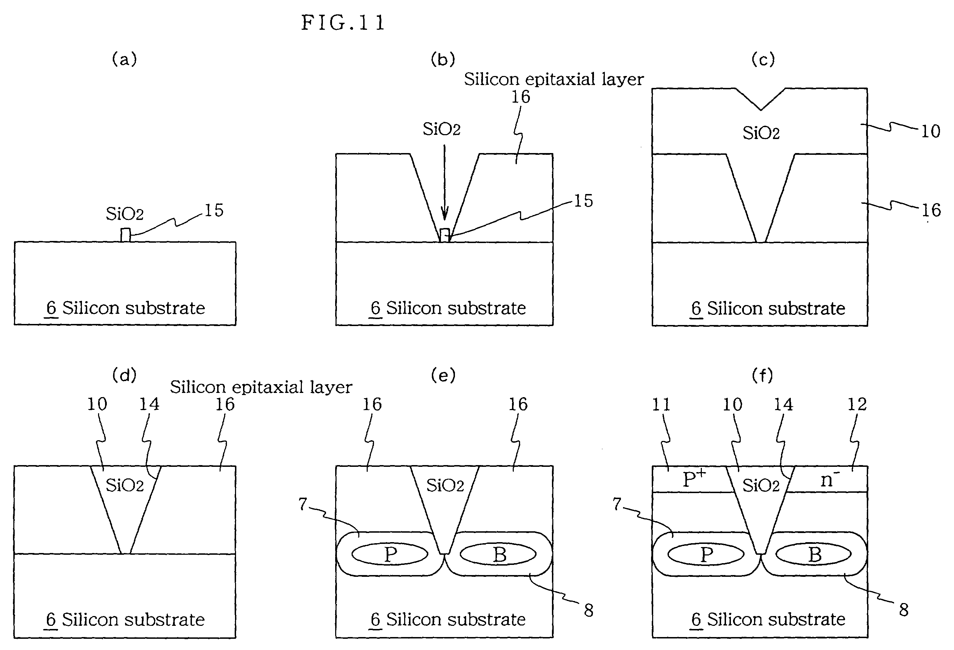

A production method of the semiconductor device having the above structure will be described with reference to FIGS. 11(a) through 11(f).

First, as shown in FIG. 11(a), an SiO₂ stripe 15 having, for example, width of 10 nm is formed on a silicon substrate 6.

Next, as shown in FIG. 11(b), a Si epitaxial layer 16 is selectively grown on the silicon substrate 6 with using UHV-CVD. At this time, the Si epitaxial layer 16 is grown with a certain angle from a part of the SiO₂ stripe 15.

After that, as shown in FIG. 11(c), a trench formed by a facet of Si epitaxial layer 16 is filled with an SiO₂ film 10 by depositing the SiO₂ film 10 on the entire surface by CVD.

Next, as shown in FIG. 11(d), the surface is made to be flat by removing the SiO₂ film 10 on the Si epitaxial layer 16 by CMP.

After forming the trench isolation structure in this manner, as shown in FIG. 11(e), a p-well layer 8 and an n-well layer 7 are formed by ion-implanting boron in the part of the p-well layer 8 and phosphorus in the part of the n-well layer 7. The order of this ion implantation is optional.

After that, as shown in FIG. 11(f), the p⁺ diffused layer 11 and n⁺ diffused layer 12 that become a source and a drain of a p-channel transistor and those of an n-channel transistor respectively are formed.

### (Sixth embodiment)

FIG. 6 is a cross-sectional view showing an isolation structure of a semiconductor device of this embodiment.

As shown in FIG. 6, a trench isolation structure itself in the semiconductor device of this embodiment is similar to those of the first to fourth embodiments.

In addition, this embodiment is characterized in that boron is used as a p-type impurity constructing the p-well layer 8, and in particular, As is used as an n-type impurity constructing an n-well layer 18.

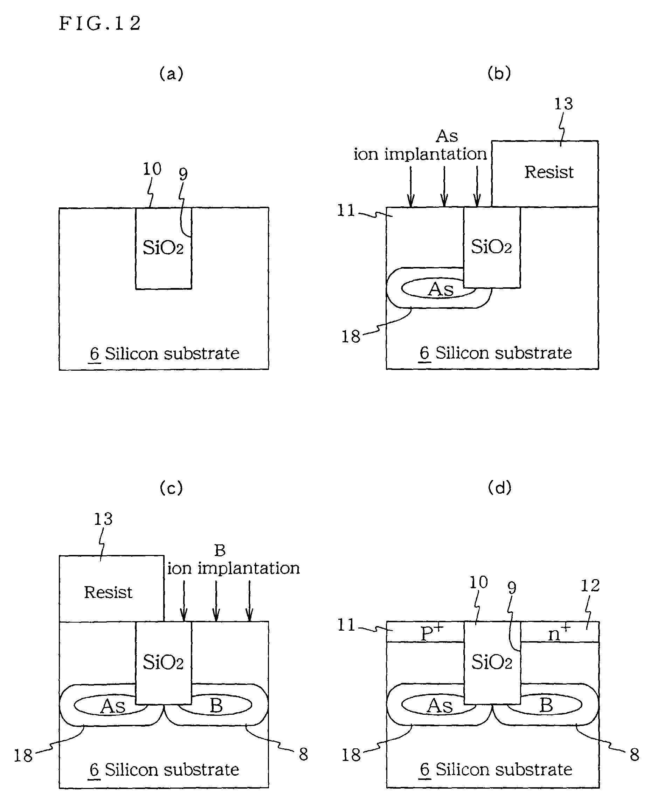

A production method of the semiconductor device having the above structure will be described with reference to FIGS. 12(a) through 12(d).

First, as shown in FIG. 12(a), the trench 9 is formed on a silicon substrate 6 with using a well-known method, and a trench isolation structure is formed by filling the trench 9 with SiO₂ 10.

Next, as shown in FIG. 12(b), the part of the p-well layer 8 is masked with a resist 13 and the like, and As is ion-implanted in the part of the n-well layer 18. After the ion implantation, the resist 13 is removed.

Next, as shown in FIG. 12(c), the part of the n-well layer 18 is masked with the resist 13 and the like, and boron is ion-implanted in the part of the p-well layer 8.

After that, as shown in FIG. 12(d), the p⁺ diffused layer 11 and n⁺ diffused layer 12 that become a source and a drain of a p-channel transistor and those of an n-channel transistor respectively are formed.

In addition, the order of the ion implantation of boron and As that is shown in FIGS. 12(b) and 12(c) can be reversed.

In addition, a technical range of the present invention is not limited to the above embodiments, but it is apparent that working modes different in a wide range can be formed on the basis of the present invention without departing from the spirit and scope of the present invention. For example, it is possible to adopt a structure obtained by combining all of the first to sixth embodiments. As an example, it is good to adopt such a structure that a junction of a concentration distribution of As and a concentration distribution of boron protrudes toward the concentration distribution of boron instead of being in the center of a trench by combining the third embodiment with the sixth embodiment, and using As as an n-type impurity and boron as a p-type impurity. In that case, it is possible to further surely suppress the punch-through between a p⁺ diffused layer and a p-well layer with an effect by using As and an effect by the position of the junction.

As described above in detail, according to a semiconductor device of the present invention, it is rare that a bottom portion of the trench becomes a p-type region or a punch-through stopper composed of the n-type impurity is formed even if the bottom portion of the trench becomes a p-type region by the pileup of boron occurring in the bottom portion of the trench. Therefore, it is possible to suppress the punch-through between the p⁺ diffused layer and p-well layer. In consequence, it is possible to provide the semiconductor device having a high isolation withstand voltage.

The invention may be embodied in other specific forms without departing from the spirit or essential characteristic thereof. The present embodiments are therefore to be considered in all respects as illustrative and not restrictive, the scope of the invention being indicated by the appended claims rather than by the foregoing description and all changes which come within the meaning and range of equivalency of the claims are therefore intended to be embraced therein.

The entire disclosure of Japanese Patent Application No. 10-077990 (Filed on March 25^{th}, 1998) including specification, claims, drawings and summary are incorporated herein by reference in its entirety.

## Claims

1. A semiconductor device having such an isolation structure that a trench, filled with a silicone oxide film, isolates an n-well layer from a p-well layer that are formed on a silicon substrate, wherein a peak of a concentration distribution of boron, constructing the p-well layer, in the direction of substrate depth lies in a side wall portion of the trench.

2. A semiconductor device having such an isolation structure that a trench, filled with a silicone oxide film, isolates an n-well layer from a p-well layer that are formed on a silicon substrate, wherein a peak of a concentration distribution of an n-type impurity, which constructs the n-well layer, in the direction of substrate depth lies at a position shallower than that of a peak of a concentration distribution of boron, which constructs the p-well layer, in the direction of substrate depth.

3. A semiconductor device having such an isolation structure that a trench, filled with a silicone oxide film, isolates an n-well layer from a p-well layer that are formed on a silicon substrate, wherein a junction of a concentration distribution of an n-type impurity and a concentration distribution of boron lies nearer to the concentration distribution of boron than to the center of the trench.

4. A semiconductor device having such an isolation structure that a trench, filled with a silicone oxide film, isolates an n-well layer from a p-well layer that are formed on a silicon substrate, wherein concentration of an n-type impurity constructing the n-well layer is higher than that of boron constructing the p-well layer.

5. A semiconductor device having such an isolation structure that a trench, filled with a silicone oxide film, isolates an n-well layer from a p-well layer that are formed on a silicon substrate, wherein a trench is formed in such a wedge-like shape that a side near to a surface of the silicon substrate is wide and a side near to the bottom portion is narrow, and
wherein at least a peak of a concentration distribution of boron, constructing the p-well layer, in the direction of substrate depth lies in a side wall portion of the wedge-like trench.

6. A semiconductor device having such an isolation structure that a trench, filled with a silicone oxide film, isolates an n-well layer from a p-well layer that are formed on a silicon substrate, wherein As is used as an n-type impurity constructing the n-well layer.
